# EUROPÄISCHE PATENTSCHRIFT

(11) **EP 1 046 661 B1**
(45) Veröffentlichungstag und Bekanntmachung des Hinweises auf die Patenterteilung: **15.09.2004**
(21) Anmeldenummer: 00107538.1
(22) Anmeldetag: 07.04.2000
(51) Int. Cl.: C08G 59/14

(54) **Flammwidrige phosphormodifizierte Epoxidharze**
Flame retardant phosphorus modified epoxy resins
Résines époxy ignifuges, modifiées par du phosphore

(30) Priorität: 19.04.1999 DE 19917428
(43) Veröffentlichungstag der Anmeldung: 25.10.2000
(73) Patentinhaber: Clariant GmbH, 65929 Frankfurt am Main (DE)
(72) Erfinder: Hörold, Sebastian, Dr., 50374 Erftstadt (DE)

(56) Entgegenhaltungen:
- EP-A- 0 794 205
- WO-A-98/13407
- DE-A- 4 308 184

## Beschreibung

Die vorliegende Erfindung betrifft neue flammwidrige phosphorhaltige Epoxidharze, ein Verfahren zu deren Herstellung und ihre Verwendung. Die neuen phosphorhaltigen Epoxidharze zeichen sich neben ihrer Flammwidrigkeit vor allem durch eine gute Lagerstabilität aus.

Epoxidharze werden heute zur Herstellung von Formmassen und Beschichtungen mit hohen thermischen, mechanischen und elektronischen Eigenschaften eingesetzt. Sie sind geeignet zum Verguß von elektrischen bzw. elektronischen Bauteilen und für Tränk- und Imprägnierprozesse. In der Elektrotechnik werden die verwendeten Epoxidharze überwiegend flammwidrig ausgerüstet und für Leiterplatten und Isolatoren eingesetzt.

Epoxidharze für Leiterplatten werden bisher durch Einreagieren bromhaltiger aromatischen Verbindungen, insbesondere Tetrabrombisphenol A, flammwidrig eingestellt. Nachteilig ist, daß im Brandfall Bromwasserstoff freigesetzt wird, was zu Schäden durch Korrosion führen kann. Unter ungünstigen Bedingungen können auch polybromierte Dibenzodioxine und Furane entstehen. Für eine gefahrlose Entsorgung dieser Leiterplatten nach Gebrauch durch Verbrennung muß ein erheblicher technischer Aufwand getrieben werden.

Die Verwendung von Aluminiumhydroxid ist eingeschränkt durch die Wasserabspaltung bei höheren Temperaturen. In der PCT WO 98/31538 wird die Verwendung von Aluminiumhydroxid als Flammschutzmittel für NEMA (National Electrical Manufactures Association) CEM 3 Epoxidharzlaminate beschrieben. Für die NEMA FR-4 und FR-5 Qualitäten kann dagegen Aluminiumhydroxid bislang nicht eingesetzt werden.

Eine effektive Art, Epoxidharze flammwidrig einzustellen, ist die Verwendung phosphororganischer Verbindungen. Nicht reaktiv gebundene Verbindungen können aber aus den Laminaten migrieren und die elektrischen Werte beeinträchtigen. Epoxidharze mit chemisch gebundenem Phosphor können dadurch gewonnen werden, daß man Epoxidharze mit P-OH Gruppen phosphororganischer Verbindungen umsetzt, wobei sich die P-OH Gruppe an den Oxiran Ring addiert. Es entstehen phosphormodifizierte Epoxidharze, die noch reaktiv sind und mit üblichen Härtern gehärtet werden können.

Die DE-OS 26 52 007 beschreibt die Umsetzung von Epoxidharzen mit Phospholanen.

Die DE-OS 43 08 184 beschreibt Epoxidharzmischungen aus einem aromatischen Polyamin als Härter und einem phosphormodifizierten Epoxidharz. Dieses phosphormodifizierte Epoxidharz ist aus Struktureinheiten aufgebaut, die sich von Polyepoxidverbindungen und mindestens einer Verbindung aus der Gruppe Phosphinsäuren, Phosphonsäuren, Pyrophosphonsäuren und Phosphonsäurehalbester ableiten.

Die DE-OS 43 08 187 beschreibt ebenfalls Epoxidharzmischungen aus einem aromatischen Polyamin als Härter und einem phosphormodifizierten Epoxidharz. Dieses phosphormodifizierte Epoxidharz ist aus Struktureinheiten aufgebaut, die sich von Polyepoxidverbindungen und Phosphinsäureanhydriden und/oder Phosphonsäureanhydride ableiten.

Die DE-OS 196 13 066 beschreibt phosphormodifizierte Epoxidharze aus Polyepoxidverbindungen und carboxylgruppenhaltigen Phosphin- oder Phosphonsäuren.

Der chemische Einbau von Phosphorverbindungen in Epoxidharze muß einerseits eine hinreichende Flammwidrigkeit bewirken, darf aber andererseits nicht zu einer Beeinträchtigung der mechanischen, chemischen und elektrischen Eigenschaften der ausgehärteten Harze führen.

Eine Verminderung der Haftung von Geweben bei der Prepreg- oder Composite-Herstellung ist ebenfalls zu vermeiden. Schließlich müssen die Lagerstabilitäten von Epoxidharzlösungen und Prepregs für den technischen Einsatz ausreichend sein. Es besteht deshalb ein Bedarf an einer verbesserten Ausrüstung von Epoxidharzen mit halogenfreien Flammschutzmitteln.

Aufgabe der vorliegenden Erfindung ist es, Epoxidharze mit technisch einfach zugänglichen Phosphorverbindungen mit hohem Phosphorgehalt flammwidrig auszurüsten, wobei sich die aus diesen Epoxidharzen nach entsprechender Härtung erhaltenen Formkörper durch gute mechanische und elektrische Eigenschaften auszeichen.

Die phosphorhaltigen Epoxidharze, welche noch keinen Härter enthalten, sollen eine hinreichende Lagerstabilität, auch in Lösung, aufweisen. Die so erhaltenen Epoxidharze sollten zudem ähnlich zu verarbeiten sein wie die derzeit im technischen Einsatz befindlichen Materialien, d.h. nicht zu verarbeitungstechnischen Problemen führen.

Die Aufgabe wird gelöst durch flammwidrige phosphormodifizierte Epoxidharze mit einem Epoxidwert von 0,05 bis 1,0 mol/100 g, enthaltend Struktureinheiten, die sich ableiten von
(A) Polyepoxidverbindungen mit mindestens zwei Epoxidgruppen pro Molekül und
(B) organischen Phosphinsäuren.

Bevorzugt entsprechen die organischen Phosphinsäuren der allgemeinen Formel (II), 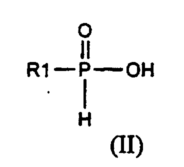 in denen R1 für eine Alkylgruppe mit 1 bis 10 Kohlenstoffatomen oder eine Arylgruppe mit 2 bis 10 Kohlenstoffatomen steht.

Bevorzugt ist R1 eine Methyl-oder eine Ethylgruppe.

Bevorzugt enthalten die erfindungsgemäßen flammwidrige phosphormodifizierte Epoxidharze im Mittel mindestens eine Epoxidgruppe.

Bevorzugt enthalten die erfindungsgemäßen flammwidrige phosphormodifizierte Epoxidharze 1 bis 8 Gew.-% Phosphor.

Die Aufgabe wird auch gelöst durch Verfahren zur Herstellung von flammwidrigen phosphormodifizierten Epoxidharzen aus Epoxidharzen und organischen Phosphinsäuren Formel (II), dadurch gekennzeichnet, daß man die Polyepoxidverbindungen gemäß (A) und die organischen Phosphin- oder Phosphonigsäuren gemäß (B)miteinander umsetzt.

Bevorzugt erfolgt die Umsetzung in einem Lösungsmittel.

Bevorzugt werden polare aprotische Lösungmittel, wie N-methylpyrrolidon, Dimethylformamid, Tetrahydrofuran, Dioxan, Ether wie Dialkylether und Glykolether, Ketone wie Methylethylketon und/oder Ester wie Ethylacetat eingesetzt.

Bei der Umsetzung mit den Phosphinsäuren nach Formel (II) erfolgt diese zunächst bei Temperaturen von 80 bis 120 °C bis zur Abreaktion der Säurefunktion und dann weiter bei Temperaturen von 150 bis 180 °C in Gegenwart von Katalysatoren.

Als Katalysatoren werden bevorzugt Phosphoniumsalze, Ammoniumsalze, Metallocene und/oder Lewis-Säuren eingesetzt.

Bevorzugt beträgt das Äquivalentverhältnis zwischen Polyepoxidverbindung (A) und organischen Phosphin- oder Phosphonigsäuren (B) 1 : 0,1 bis 1 : 1.

Das Molverhältnis von Polyepoxidverbindung zu Phosphorverbindung kann variiert werden, so daß Umsetzungsprodukte mit verschiedenen Phosphorgehalten und Epoxidwerten entstehen.

Die Erfindung betrifft auch die Verwendung der erfindungsgemäßen flammwidrigen phosphormodifizierten Epoxidharze zur Herstellung von Formkörpem, Composites, Beschichtungen oder Laminaten.

Wie vorstehend beschrieben, erfolgt die Umsetzung der Phosphinsäuren bei Temperaturen von 70 bis 100 °C und kann durch Messung der Säurezahl kontrolliert werden.

Die Umsetzung mit phophonigen Säuren der allgemeinen Formel (II) läuft dagegen zweistufig ab. Bei Temperaturen im Bereich von 80 bis 120 °C reagiert zunächst die Säurefunktion mit der Epoxidgruppe. Nach Beendigung dieser Reaktion wird die Temperatur auf 150 bis 180 °C erhöht und Katalysatoren zugesetzt, so daß die P-H-Gruppe mit dem Epoxid reagiert. Die Umsetzung läßt sich mittels ³¹P-NMR spektroskopisch verfolgen.

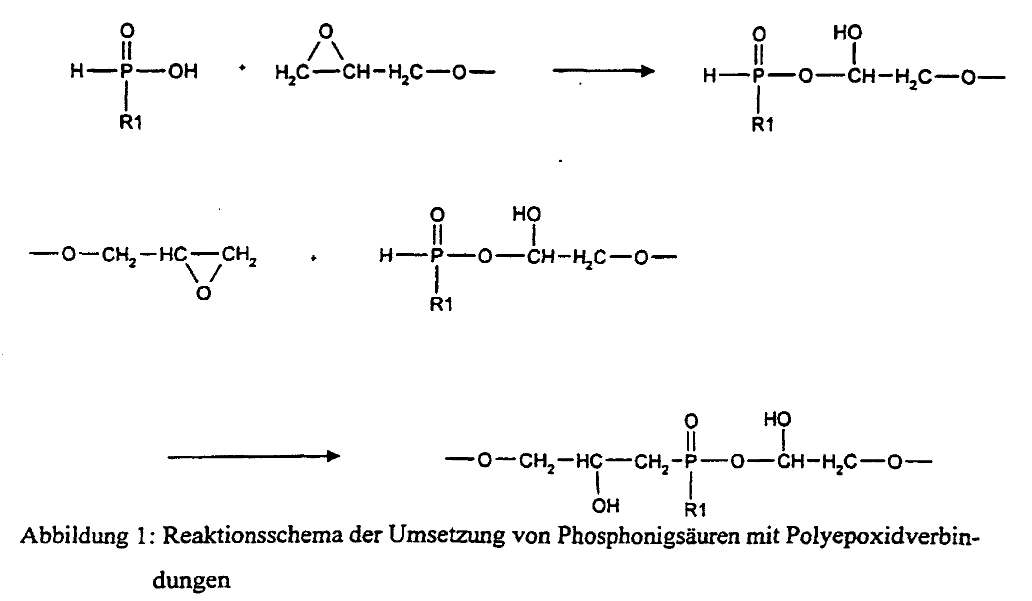

Die difunktionellen Phosphonigsäuren lassen sich mit difunktionellen Epoxidharzen umsetzen.

Die nach dem erfindungsgemäßen Verfahren erhaltenen phosphormodifizierten Epoxidharze können - wie beschrieben - zur Herstellung von Laminaten, Composites, Formkörpern oder Beschichtungen eingesetzt werden.

Epoxidharze sind Verbindungen, die durch Polyadditionsreaktion von einer Epoxidharz-Komponente und einer Vernetzungs-(Härter) Komponente hergestellt werden. Als Epoxidharz Komponente werden aromatische Polyglycidylether wie Bisphenol-A-diglycidylether, Bisphenol-F-diglycidylether, Polyglycidylether von Phenol-Formaldehydharzen und Kresol-Formaldehydharzen, Polyglycidylester von Pththal-, Isophthal- und Terephthalsäure sowie von Trimellithsäure, N-Glycidylverbindungen von aromatischen Aminen und heterocyclischen Stickstoffbasen sowie Di- und Polyglycidylverbindungen von mehrwertigen aliphatischen Alkoholen verwendet.

Als Härter finden Polyamine wie Triethylentetramin, Aminoethylpiperazin und Isophorondiamin, Polyamidoamine, mehrbasige Säure oder deren Anhydride wie z.B. Phthalsäureanhydrid, Hexahydrophthalsäureanhydrid, Methyltetrahydrophthalsäureanhydrid oder Phenole Verwendung. Die Vernetzung kann auch durch Polymerisation unter Verwendung geeigneter Katalysatoren erfolgen. Für Leiterplatten wird meist Dicyandiamid als Härter verwendet.

Der Brandschutz elektrischer und elektronischer Ausrüstungen ist in verschiedenen Vorschriften und Normen zur Produktsicherheit festgelegt. In den USA werden brandschutztechnische Prüf- und Zulassungsverfahren von Underwriters Laboratories (UL) durchgeführt. Die UL-Vorschriften werden heute weltweit akzeptiert. Die Brandprüfungen für Kunststoffe wurden entwickelt, um den Widerstand der Materialien gegenüber Entzündung und Flammenausbreitung zu ermitteln. Je nach Brandschutzanforderungen müssen die Materialien horizontale Brenntests (Klasse UL 94 HB) oder die strengeren vertikalen Tests (UL 94 V2, V1 oder V-0) bestehen. Die Prüfungen simulieren Zündquellen geringer Energie, die in Elektrogeräten auftreten und auf Kunststoffteile elektrischer Baugruppen einwirken können.

Nachfolgend wird die Erfindung durch Beispiele erläutert:

### Beispiel 1 (Methanphosphonigsäure)

In einem 250 ml Fünfhalskolben mit Rückflußkühler, Rührerwelle, Thermometer und Gaseinleitungsrohr werden 200 g eines flüssigen Bisphenol-A Epoxidharzes mit einem Epoxidwert von 0,55 mol/100g und einer Funktionalität von 2 mit 16 g Methanphosphonigsäure (0,2 mol) versetzt. Unter Rühren und Stickstoffüberleitung wird die Temperatur auf 100 °C erhöht und etwa 1 h bei 100 °C gehalten. Das Fortschreiten der Umsetzung wird durch Messung der Säurezahl verfolgt. Nach Zugabe von 0,4 g Tetramethylphosphoniumbromid wir die Temperatur auf 150 °C erhöht. Nach ewta 2 h Reaktionszeit bei 150 °C wird die Reaktionsmischung abkühlen gelassen und mit 40 g Methyethylketon zu einer farblosen, viskosen Lösung verdünnt. Das ³¹P-NMR Spektrum zeigt mehrere Linien zwischen 50 und 60 ppm, die für Phosphinsäuren typisch sind.

### Beispiel 2 (Ethanphosphonigsäure)

In einem 250 ml Fünfhalskolben mit Rückflußkühler, Rührerwelle, Thermometer und Gaseinleitungsrohr werden 200 g eines flüssigen Bisphenol-A Epoxidharzes mit einem Epoxidwert von 0,55 mol/100g mit 19 g Ethanphosphonigsäure (0,2 mol) versetzt. Unter Rühren und Stickstoffüberleitung wird die Temperatur auf 100 °C erhöht und etwa 1 h bei 100 °C gehalten. Das Fortschreiten der Umsetzung wird durch Messung der Säurezahl verfolgt. Nach Zugabe von 0,4 g Tetramethylphosphoniumbromid wir die Temperatur auf 150 °C erhöht. Nach ewta 2 h Reaktionszeit bei 150 °C wird die Reaktionsmischung abkühlen gelassen und mit 40 g Methyethylketon zu einer farblosen, viskosen Lösung verdünnt. Das ³¹P-NMR-Spektrum zeigt mehrere Linien zwischen 50 und 60 ppm, die für Phosphinsäuren typisch sind.

### Beispiel 3:

Mit 125 g Epoxidharzlösung nach Beispiel 1 und 30 g Dyhard L 10 (SKW Trostberg, Lösung von Dicyandiamid in Methylglycol) sowie 0,1 g Dyhard MI (SKW Trostberg) werden Glasgewebe (200 g/m², Finish Z 6040 von Dow Corning) imprägniert, getrocknet und vorreagiert. Es werden klebfreie Prepregs erhalten. 8 Lagen des so erhaltenen Prepregs werden bei 180 °C und 50 bar zu einer Platte verpreßt. Aus dieser Platten werden Prüfkörper von 217 mm Länge und 12,7 mm Breite gesägt. Die Dicke der Materialien beträgt etwa 1,6 mm.

### Beispiele 4 bis 6:

Mit den Epoxidharzlösungen nach Beispiel 2, wird in analoger Weise ein Glasfaserverstärktes Laminat hergestellt.

Die Prüfung des Brandverhaltens wurde nach der Vorschrift von Underwriters Laboratories "Test for Flammability of Plastic Materials - UL 94" in der Fassung vom 02.05.1975 durchgeführt. Tabelle 1 zeigt die Brandergebnisse der Laminate nach den Beispielen 4 bis 8.

**Tabelle 1**

| Brandprüfungen nach UL 94 | | | |
|---|---|---|---|
| Laminat | Phosphormodifiziertes Epoxidharz aus | Nachbrennzeit * | UL 94 Klassifizierung |
| Beispiel 3 | Beispiel 1 | <1'; < 1' | V-0 |
| Beispiel 4 | Beispiel 2 | <1'; 3' | V-0 |

| | | | |
|---|---|---|---|
| * Die Nachbrennzeit gibt entsprechend dem UL 94-Test die Zeit des Nachbrennens des Materials in Sekunden an. | | | |

Die mit den erfindungsgemäßen flammwidrige phosphormodifizierte Epoxidharzen ausgerüsteten und gehärteten Epoxidharze zeigen eine ausgezeichnete Flammwidrigkeit.

## Patentansprüche

1. Flammwidrige phosphormodifizierte Epoxidharze mit einem Epoxidwert von 0,05 bis 1,0 mol/100 g, enthaltend Struktureinheiten, die sich ableiten von
(A) Polyepoxidverbindungen mit mindestens zwei Epoxidgruppen pro Molekül und
(B) Phosphinsäuren der allgemeinen Formel (II), 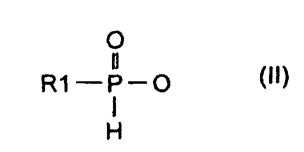 in der R1 für eine Alkylgruppe mit 1 bis 10 Kohlenstoffatomen oder eine Arylgruppe mit 2 bis 10 Kohlenstoffatomen steht.

2. Flammwidrige phosphormodifizierte Epoxidharze nach Anspruch 1, **dadurch gekennzeichnet, daß** R1 für eine Methyl-oder eine Ethylgruppe steht.

3. Flammwidrige phosphormodifizierte Epoxidharze nach Anspruch 1 oder 2, **dadurch gekennzeichnet, daß** sie im Mittel mindestens eine Epoxidgruppe enthalten.

4. Flammwidrige phosphormodifizierte Epoxidharze nach einem oder mehreren der Ansprüche 1 bis 3, **dadurch gekennzeichnet, daß** sie 1 bis 8 Gew.-% Phosphor enthalten.

5. Verfahren zur Herstellung von flammwidrigen phosphormodifizierten Epoxidharzen aus Epoxidharzen und organischen Säuren nach Formel (II), **dadurch gekennzeichnet, daß** man die Polyepoxidverbindungen gemäß (A) und die Phosphinsäuren gemäß (B) miteinander umsetzt.

6. Verfahren nach Anspruch 5, **dadurch gekennzeichnet, daß** die Umsetzung in einem Lösungsmittel erfolgt.

7. Verfahren nach Anspruch 5 oder 6, **dadurch gekennzeichnet, daß** polare aprotische Lösungmittel, wie N-methylpyrrolidon, Dimethylformamid, Tetrhydrofuran, Dioxan, Ether wie Dialkylether und Glykolether, Ketone wie Methylethylketon und/oder Ester wie Ethylacetat eingesetzt werden.

8. Verfahren nach einem oder mehreren der Ansprüche 5 bis 7, **dadurch gekennzeichnet, daß** die Umsetzung mit den Phosphinsäuren nach Formel (II) zunächst bei Temperaturen von 80 bis 120 °C bis zur Abreaktion der Säurefunktion und dann weiter bei Temperaturen von 150 bis 180 °C in Gegenwart von Katalysatoren erfolgt.

9. Verfahren nach Anspruch 8, **dadurch gekennzeichnet, daß** als Katalysatoren Phosphoniumsalze, Ammoniumsalze, Metallocene und/oder Lewis-Säuren eingesetzt werden.

10. Verfahren nach einem oder mehreren der Ansprüche 5 bis 9, **dadurch gekennzeichnet, daß** das Äquivalentverhältnis zwischen Polyepoxidverbindung (A) und Phosphinsäuren (B) 1 : 0,1 bis 1 : 1 beträgt.

11. Verwendung der flammwidrigen phosphormodifizierten Epoxidharze nach einem oder mehreren der Ansprüche 1 bis 4 zur Herstellung von Formkörpern, Composites, Beschichtungen oder Laminaten.

## Claims

1. A flame-retardant phosphorus-modified epoxy resin with an epoxy value of from 0.05 to 1.0 mol/100 g containing structural units which derive from
(A) polyepoxy compounds having at least two epoxy groups per molecule, and
(B) phosphinic acids of the formula (II) 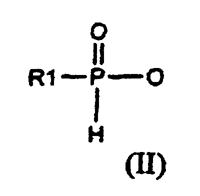
where R1 is an alkyl group having from 1 to 10 carbon atoms or an aryl group having from 2 to 10 carbon atoms.

2. A flame-retardant phosphorus-modified epoxy resin as claimed in claim 1, wherein R1 is a methyl group or an ethyl group.

3. A flame-retardant phosphorus-modified epoxy resin as claimed in claim 1 or 2, which contains, on average, at least one epoxy group.

4. A flame-retardant phosphorus-modified epoxy resin as claimed in one or more of claims 1 to 3, which contains from 1 to 8% by weight of phosphorus.

5. A process for preparing flame-retardant phosphorus-modified epoxy resins from epoxy resins and organic acids as in formula (II), which comprises reacting the polyepoxy compounds of (A) and the phosphinic acids of (B) with one another.

6. The process as claimed in claim 5 wherein the reaction takes place in a solvent.

7. The process as claimed in claim 5 or 6, wherein polar aprotic solvents are used, for example N-methylpyrrolidone, dimethylformamide, tetrahydrofuran, dioxane, ethers, such as dialkyl ethers and glycol ethers, ketones, such as methyl ethyl ketone, and/or esters, such as ethyl acetate.

8. The process as claimed in one or more of claims 6 to 7, wherein the reaction with the phosphinic acids as in formula (II) takes place first at temperatures from 80 to 120°C until the acid function has been consumed in the reaction and then continues at temperatures of from 150 to 180°C, in the presence of catalysts.

9. The process as claimed in claim 8, wherein the catalysts comprise phosphonium salts, ammonium salts, metallocenes and/or Lewis acids.

10. The process as claimed in one or more of claims 5 to 9, wherein the ratio of equivalents between polyepoxide compound (A) and phosphinic acids (B) is from 1:0.1 to 1:1.

11. The use of the flame-retardant phosphorus-modified epoxy resins as claimed in one or more of claims 1 to 4 for producing moldings, composites, coatings or laminates.

## Revendications

1. Résines époxyde ignifuges, modifiées par du phosphore avec un indice d'époxyde de 0,05 à 1,0 mol/100g, contenant des motifs de structure, qui dérivent de :
(A) composés polyépoxyde ayant au moins deux groupes époxyde par molécule et
(B) acides phosphiniques de formule générale (II) 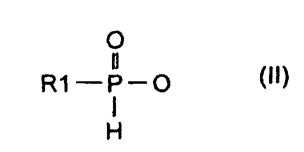
dans laquelle R1 représente un groupe alkyle avec 1 à 10 atomes de carbone ou un groupe aryle avec 2 à 10 atomes de carbone.

2. Résines époxyde ignifuges, modifiées par du phosphore selon la revendication 1, **caractérisées en ce que** R1 représente un groupe méthyle ou éthyle.

3. Résines époxyde ignifuges, modifiées par du phosphore selon la revendication 1 ou 2, **caractérisées en ce qu'**elles contiennent en moyenne au moins un groupe époxyde.

4. Résines époxyde ignifuges, modifiées par du phosphore selon une ou plusieurs des revendications 1 à 3, **caractérisées en ce qu'**elles contiennent 1 à 8 % en poids de phosphore.

5. Procédé pour la préparation de résines époxyde ignifuges, modifiées par du phosphore à partir de résines époxyde et d'acides organiques selon la formule (II), **caractérisé en ce qu'**on met à réagir ensemble Les composés polyépoxyde selon (A) et les acides phosphiniques selon (B).

6. Procédé selon la revendication 5, **caractérisé en ce qu'**on effectue la réaction dans un solvant.

7. Procédé selon la revendication 5 ou 6, **caractérisé en ce qu'**on utilise des solvants polaires aprotiques, comme la N-méthylpyrrolidone, le diméthylformamide, le tétrahydrofurane, le dioxane, les éthers comme les dialkyléthers et les éthers de glycol, les cétones comme la méthyléthylcétone et/ou les esters comme l'acétate d'éthyle.

8. Procédé selon une ou plusieurs des revendications 5 à 7, **caractérisé en ce qu'**on réalise la réaction avec les acides phosphiniques selon la formule (II) d'abord à des températures de 80 à 120 °C jusqu'à ce que la fonction acide ait été consommée dans la réaction et ensuite on continue à des températures de 150 à 180 °C en présence de catalyseurs.

9. Procédé selon la revendication 8, **caractérisé en ce qu'**on utilise comme catalyseurs des sels de phosphonium, des sels d'ammonium, des métallocènes et/ou des acides de Lewis.

10. Procédé selon une ou plusieurs des revendications 5 à 9, **caractérisé en ce que** le rapport équivalent entre le composé polyépoxyde (A) et les acides phosphiniques (B) est de 1 : 0,1 à 1 : 1.

11. Utilisation des résines époxyde ignifuges, modifiées par du phosphore selon une ou plusieurs des revendications 1 à 4 pour la préparation de pièces moulées, de composites, de revêtements ou de stratifiés.
